(19) Europäisches Patentamt
European Patent Office
Office européen des brevets

(11) **EP 3 492 803 A1**

(12) **EUROPEAN PATENT APPLICATION**
published in accordance with Art. 153(4) EPC

(43) Date of publication:
**05.06.2019 Bulletin 2019/23**

(51) Int Cl.:
**F21S 41/00** *(2018.01)* **F21Y 115/30** *(2016.01)*

(21) Application number: **17834117.8**

(22) Date of filing: **19.07.2017**

(86) International application number:
**PCT/JP2017/026082**

(87) International publication number:
**WO 2018/021109 (01.02.2018 Gazette 2018/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **29.07.2016 JP 2016150726**

(71) Applicant: **Panasonic Intellectual Property Management Co., Ltd.**
**Osaka-shi, Osaka 540-6207 (JP)**

(72) Inventors:
• **MURAKAMI Kimihiro**
**540-6207 Osaka (JP)**
• **KOGA Toshihiro**
**540-6207 Osaka (JP)**
• **MATSUMURA Kazuyuki**
**540-6207 Osaka (JP)**

(74) Representative: **Appelt, Christian W.**
**Boehmert & Boehmert**
**Anwaltspartnerschaft mbB**
**Pettenkoferstrasse 22**
**80336 München (DE)**

(54) **LIGHT EMISSION DEVICE AND ILLUMINATION DEVICE**

(57) A light emission device (1) includes a plurality of light sources (100, 200), a light deflector (140) that deflects excitation light beams (101, 201) emitted by the plurality of light sources (100, 200), and a wavelength converter (160) that receives and converts the excitation light beams (101, 201) deflected by the light deflector (140) to wavelength-converted light of a different wavelength, and emits the wavelength-converted light. The light deflector (140) includes one movable mirror (142) on which the excitation light beams (101, 201) are incident along different optical axes. The excitation light beams (101, 201) have equally long optical path lengths from the one movable mirror (142) to the wavelength converter (160).

FIG. 3

## Description

TECHNICAL FIELD

The present disclosure relates to (i) light emission devices in which a light source emits an excitation light beam on a wavelength converter which in turn generates light of a different wavelength from the excitation light beam, and (ii) illumination devices including the light emission device.

BACKGROUND ART

Illumination devices using a laser light source such as a semiconductor light-emitting device (laser diode) are found in spotlights, headlights for cars, projectors, endoscopes, and the like. In these illumination devices, laser light with a wavelength of approximately 400 nm or 450 nm is radiated on a wavelength converter which consists of a fluorescent substance typically made of yttrium aluminium garnet (YAG). Fluorescent light generated by exciting the fluorescent substance, or emission light consisting of fluorescent light and scattered excitation light is used as illumination light. In such illumination devices, since the spot size of an excitation light beam on the fluorescent substance can be made smaller by using an optical concentration system, the size of the emission area produced by the fluorescent light can be reduced more than when using a light-emitting diode (LED). Accordingly, the size of the optical system for emitting light forward can be scaled down.

There is a light emission device that includes, besides a laser light source, an optical concentration system that focuses laser light, a wavelength converter consisting of fluorescent substance, and a light deflector disposed along the optical path from the laser light source to the wavelength converter. In this light emission device, laser light is focused on the fluorescent substance using the optical concentration system, and deflected by the light deflector. Moreover, the optical path of the laser light is cyclically deflected by causing the reflection mirror of the light deflector to pivot. Here, the cycle of the pivoting reflection mirror is configured at a degree short enough that the light from the light emission device is emitted as flickers imperceptible to the human eye. With this light emission devices one can freely alter the shape of the emission area on the fluorescent substance by cyclically changing the radiation point of the laser light thereon. By adding an optical projection system for projecting wavelength-converted light produced by the wavelength converter and scattered excitation light in the forward direction of the light emission device becomes an illumination device with a light distribution angle corresponding to the coordinate region of the excitation light beam scanned on the fluorescent substance. Hereinafter, this type of light emission device and illumination device are respectively also referred to as a scanning light emission device and scanning illumination device. The scanning illumination device can, for example, be used in an adaptive headlight system (ADB: Adaptive Driving Beam) for cars. To be specific, by cyclically controlling the angle of the inclinable reflection mirror, the laser light is scanned on a coordinate region of the fluorescent substance corresponding to the light distribution one wants to project. With this, for example, for the purpose of preventing glare on drivers in oncoming vehicles or pedestrians, the laser light is turned off when it passes through the coordinate region of the fluorescent substance corresponding to the region of the faces of the drivers or pedestrians so as to not radiate light thereon. In this manner, by changing the scanning region of the laser light on the fluorescent substance, light distribution adapted to the driving conditions of the car can be achieved.

Furthermore, in illumination devices like headlights for cars, faraway targets need to be illuminated, but the luminous flux of the illumination light needs to be increased in order to achieve this. The simplest way to increase the luminous flux of the illumination light is to raise the output of the semiconductor light-emitting device, but since there is a limit to the maximum output of a single excitation light source with current technology, using a plurality of light sources to add extra output is mainly considered.

In Patent Literature (PTL) 1 and PTL 2, illumination devices that use a movable reflection mirror interacting with the plurality of light sources, radiate laser light emitted from the semiconductor light-emitting devices on a fluorescent substance, generate fluorescent light therewith, and radiate this fluorescent light forward with the optical projection system are proposed as examples of a scanning illumination device including a combination of a plurality of semiconductor light-emitting devices, a light deflector, and a wavelength converter.

Citation List

Patent Literature

PTL 1: Japanese Unexamined Patent Application Publication No. 2011-222238.
PTL 2: Japanese Unexamined Patent Application Publication No. 2014-29858.

SUMMARY OF THE INVENTION

TECHNICAL PROBLEMS

Both instances of the background art use a plurality of light deflectors each interacting with a plurality of light sources, but when using this configuration to achieve adjustable light distribution, there are some problems concerning controllability and cost due to the plurality of light deflectors.

For example, in order to achieve ADB, the plurality of light sources need to be turned ON/OFF with the same timing as the laser light of the plurality of light sources arriving at the same coordinates on the fluorescent substance along their scan axes. For this reason the plurality of light deflectors are operated with the same driving voltage pattern, and even when the plurality of light sources are turned ON/OFF simultaneously, the edges of the radiation area and non-radiation area are out of alignment since differences between the magnetic circuits for driving the light deflectors or differences caused by assembly result in time differences in the operation of the light deflectors. Such alignment problems cannot be ignored with respect to the quality of the projection light. However, even when each light reflector is controlled separately, perfectly aligning the non-radiation area involves highly strenuous adjustment work due to subtly differing oscillation patterns in the light deflector with respect to the scan coordinates.

Furthermore, using a plurality of light deflectors increases the amount of components and costs, complicates assembly, as well as making it more difficult to scale down the device due to the increase in volume thereof.

One possible method to solve these problems is to join the laser light from the plurality of light sources into one beam along one optical axis beforehand, have it be incident on one light deflector, and scan it as such. Joining the optical axes can be achieved by polarization coupling, wavelength combining, Volume Holographic Grating (VHG), and the like, but each of these requires specialized optical instruments such as a beam splitter, dichroic prism, or VHG. Moreover, specialized optical instruments increase the size of the device and its cost. At the same time, the laser light will be influenced by the optical properties (optical transparency, reflectivity, diffraction efficiency) of these optical instruments and reduce its efficiency. Additionally, adjusting the identical optical axis, curbing the influence from the thermal properties of the optical instruments, and the like pose too many problems that require attention. Furthermore, since each method for joining together more than two beams has various restrictions, such methods are difficult to implement.

In order to solve the above problems, the present disclosure provides an illumination device including a light emission device that has a plurality of light sources, a wavelength converter, a light deflector, emits high quality light, and has a streamlined configuration.

SOLUTIONS TO PROBLEMS

The light emission device according to an aspect of the present disclosure includes light sources emitting a first excitation light beam and a second excitation light beam, a light deflector that deflects the first excitation light beam and the second excitation light beam emitted by the light sources, and a wavelength converter that receives and converts the first excitation light beam and the second excitation light beam deflected by the light deflector to wavelength-converted light of a different wavelength and emits the wavelength-converted light. The light deflector includes one movable mirror on which the first excitation light beam and the second excitation light beam are incident along different optical axes.

In this light emission device with this configuration, since the configuration of the device can be simplified by integrating the light deflector, which deflects the first excitation light beam and the second excitation light beam, as the one movable mirror, the device can expectedly be scaled down, have the number of its components reduced, have its manufacturing cost cut down, and can be assembled more easily. Moreover, adjustable light distribution typical of ADB can be achieved by using headlights for cars for light emission device 1. In this case, the light sources are turned off when each excitation light beam is radiated on the coordinate region of the wavelength converter corresponding to the region of the scannable region so as to partially not radiate the emission light thereon. Here, the first excitation light beam and the second excitation light beam can be deflected by controlling the one movable mirror of the light deflector. Accordingly, in the light emission device according to the present disclosure, individual responsiveness differences between light deflectors with respect to input signals do not need to be taken in account unlike when two light deflectors are used to deflect the first excitation light beam and the second excitation light beam. Therefore, the timing of when the first excitation light beam and the second excitation light beam are radiated on the wavelength converter, along with the coordinate region where each excitation light beam is not emitted, can easily be aligned. Accordingly, the control timing between the first excitation light beam and the second excitation light beam does not need to be aligned completely, and the plurality of light sources can be controlled simultaneously with the same circuit. In this manner, the control system in the light emission device according to the present disclosure can be simplified. Furthermore, by matching the control timing of the first excitation light beam and the second excitation light beam, the output and quality of light emitted by emission device 1 can be improved.

In the light emission device according to an aspect of the present disclosure, the one movable mirror rotates about a rotation axis, and the first excitation light beam and the second excitation light beam may also propagate through a plane that includes the rotation axis and may also be incident on the one moveable mirror at equal angles.

In the light emission device with this configuration, the deflection angle and deflection direction of each excitation light beam are aligned following the tilting movement of the one movable mirror. Accordingly, the optical paths of the first excitation light beam and the second excitation light beam can easily be controlled.

In the light emission device according to an aspect of the present disclosure, the first excitation light beam and the second excitation light beam may also have equally long optical path lengths from the one movable mirror to the wavelength converter.

In this light emission device with this configuration, the radiation spot movement degree on the wavelength converter per unit of degree of the rotation angle of the one movable mirror is equal for the first excitation light beam and the second excitation light beam. As a result, the first excitation light beam and the second excitation light beam can be scanned with the same coordinates over the wavelength converter and with the same timing.

The light emission device according to an aspect of the present disclosure, the first excitation light beam and the second excitation light beam are each reflected by a corresponding one of two reflectors to the wavelength converter, the two reflectors being symmetrically disposed with respect to a normal line of an incidence surface of the wavelength converter on which the first excitation light beam and the second excitation light beam are incident.

In this light emission device with this configuration, when the first excitation light beam and the second excitation light beam are scanned over the same position, a symmetrical light distribution with respect to the center of the radiation direction can be achieved when radiating the emission light forward from the fluorescent substance using an optical projection system and the like since a symmetrical scan shape can be obtained with respect to the center of the scan area of each excitation light beam on the fluorescent substance.

In the light emission device according to an aspect of the present disclosure, the wavelength converter may also be a fluorescent substance.

In the light emission device with this configuration, the wavelengths of the first excitation light beam and the second excitation light beam can be converted by the wavelength converter.

The illumination device according to an aspect of the present disclosure includes the above light emission device, and an optical projection system for radiating on an illumination target (i) the wavelength-converted light emitted from the wavelength converter that receives the first excitation light beam and the second excitation light beam, and (ii) light scattered from the first excitation light beam and the second excitation light beam by the wavelength converter.

The illumination device with this configuration can be used for various types of illumination devices that require a specific light distribution, such as headlights for cars or spotlights, due to the first excitation light beam and the second excitation light beam being deflected by the light deflector and scanned over the wavelength converter. Furthermore, the illumination device with the present configuration can freely adjust its light distribution.

In the illumination device according to an aspect of the present disclosure, an incidence surface of the wavelength converter on which the first excitation light beam and the second excitation light beam are incident may also face the optical projection system.

In the illumination device with this configuration, the incident and emission surfaces of the wavelength converter are the same, and efficiently dissipate heat since it is possible to dispose a highly thermally conductive component on the opposite side of the incident and emission surfaces. Accordingly, the illumination device can be made with high light-conversion efficiency, thermal properties and durability.

ADVANTAGEOUS EFFECTS OF INVENTION

The present disclosure achieves with the same controllability as when only one excitation light beam is used (i) a bright, compact light emission device which minimizes manufacturing cost due to its simple configuration, and (ii) an illumination device that can project light forward while changing its complex distribution patterns over time adapting to the conditions of the illumination target typically used in ADB.

Moreover, since the plurality of excitation light beams is transmitted along separate optical axes up until the fluorescent substance, the time and effort needed to configure the optical system to create a beam along one optical axis and adjusting the optical axis can be avoided.

BRIEF DESCRIPTION OF DRAWINGS

FIG. 1 is a lateral view showing an optical system configuration of a light emission device and an illumination device according to an embodiment.

FIG. 2 is an enlarged view of an area proximate to a light deflector of the light emission device according to the embodiment.

FIG. 3 is a perspective view showing the optical system configuration of the light emission device and the illumination device according to the embodiment.

FIG. 4 is a perspective view showing a rough outline of a semiconductor light-emitting device used in the light emission device and a radiation pattern of laser light emitted by the semiconductor light-emitting device according to the embodiment.

FIG. 5 is a lateral view showing a placement of a cylindrical mirror of the light emission device according to the embodiment.

FIG. 6 is a graph showing a wavelength distribution of light emitted outward from a fluorescent substance according to the embodiment.

FIG. 7A shows a relationship between a focal length of an optical projection system and a radiation angle along an x-axis of projection light according to the embodiment.

FIG. 7B shows the relationship between the focal length of the optical projection system and the radiation angle along a y-axis of the projection light according to the embodiment.

FIG. 8 shows an example of a relationship between rotation angles of a movable mirror and radiation spot shapes of an excitation light beam on a surface of the fluorescent substance in the light emission device according to the embodiment.

FIG. 9 is a lateral view showing the optical system configuration of the light emission device and the illumination device according to a variation.

FIG. 10 is a lateral view showing the optical system configuration of the light emission device and the illumination device according to another variation.

## DESCRIPTION OF EXEMPLARY EMBODIMENT

Hereinafter, embodiments of the present disclosure will be described in detail. Note that each of the embodiments described below shows a specific example of the present disclosure. Numerical values, shapes, materials, components, placement and connection of the components, steps, the order of steps, and the like in the following embodiments are mere examples and are not intended to limit the present disclosure. Moreover, components in the following embodiments not mentioned in any of the independent claims that define the broadest concepts are described as optional elements.

Moreover, the drawings are schematic diagrams and do not necessarily provide strictly accurate illustrations. Therefore, the scales and the like in the drawings do not necessarily coincide.

## EMBODIMENT

A light emission device and an illumination device according to the embodiment will be described with reference to the drawings.

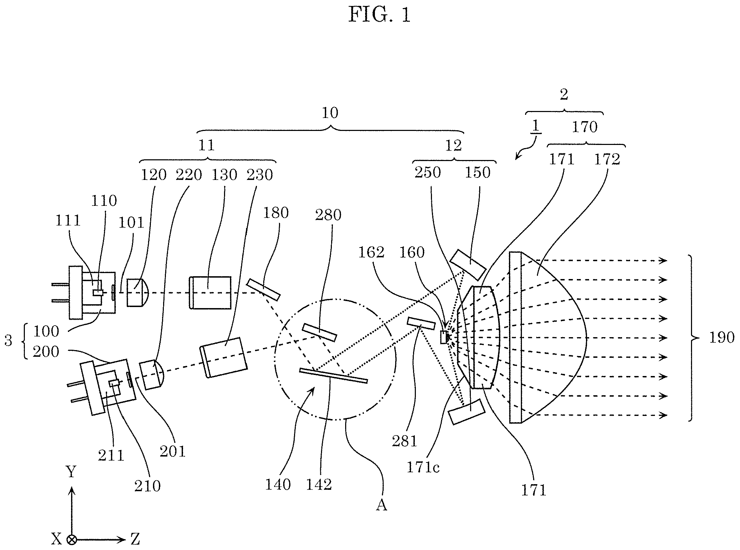

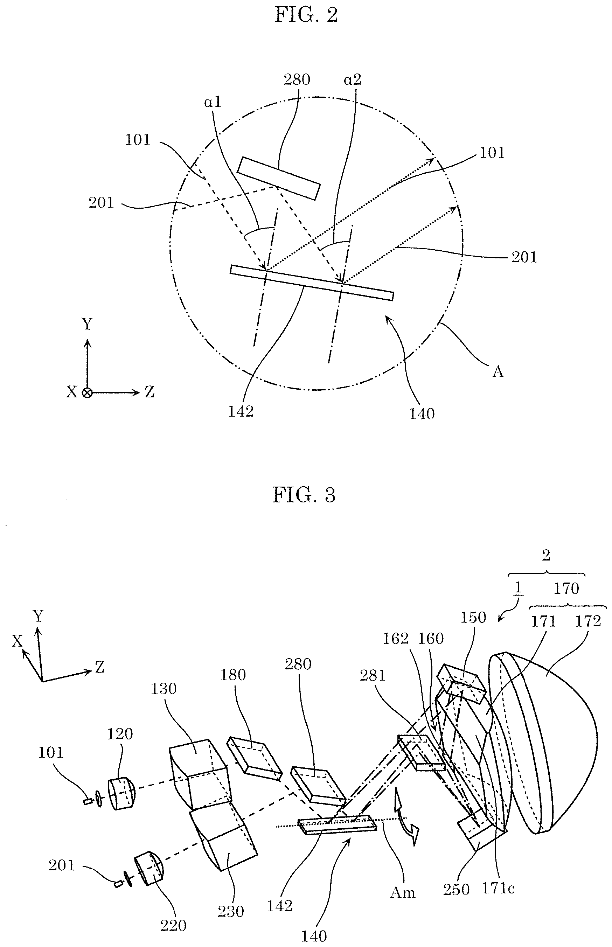

FIG. 1 is a lateral view showing an optical system configuration of light emission device 1 and illumination device 2 according to the embodiment. FIG. 2 is an enlarged view of area A proximate to light deflector 140 of light emission device 1 according to the embodiment. FIG. 3 is a lateral view showing the optical system configuration of light emission device 1 and illumination device 2 according to the embodiment. In FIGs 1 and 3, a z-axis is an optical axis of projection light 190 projected from illumination device 2, and x- and y-axes are perpendicular to the optical axis and intersect each other.

Illumination device 2 according to the present embodiment is a device for emitting projection light 190, and includes, as illustrated in FIG. 1, light emission device 1 and optical projection system 170. Light emission device 1 includes light source 3, light deflector 140, and wavelength converter 160. Light emission device 1 further includes fixed mirrors 180, 280, and 281.

Light source 3 emits first excitation light beam 101 and second excitation light beam 201, and includes semiconductor lasers 100 and 200. Semiconductor lasers 100 and 200 respectively emit first excitation light 101 and second excitation light beam 201. Semiconductor laser 100 mainly includes submount 111 and semiconductor light-emitting device 110 fixed thereto. Semiconductor laser 200 mainly includes submount 210 and semiconductor light-emitting device 210 fixed thereto.

Semiconductor light-emitting device 110 is a semiconductor laser that emits first excitation light 101 which is laser light. Hereinafter, semiconductor light-emitting device 110 will be described with reference to the drawings.

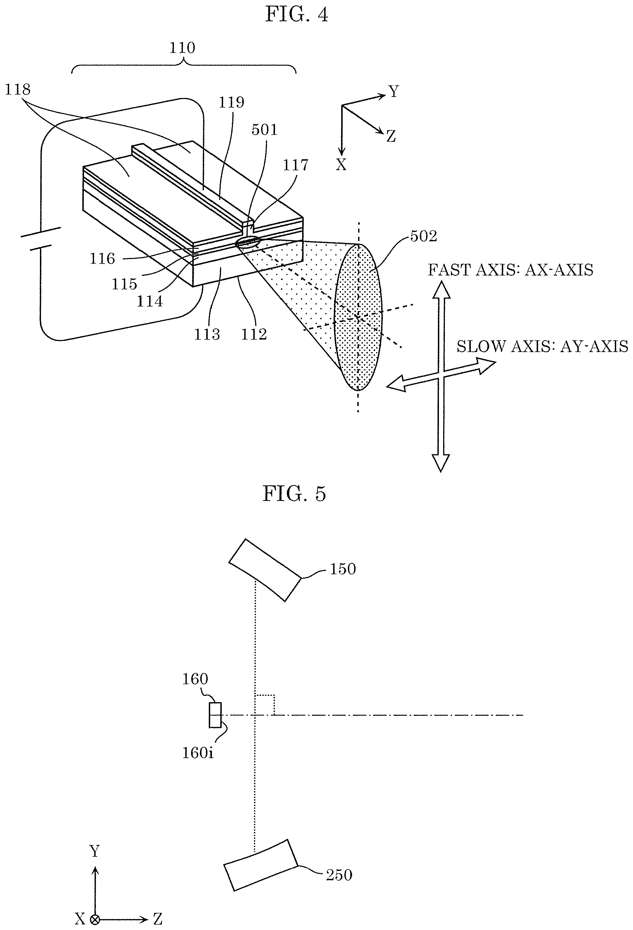

FIG. 4 is a perspective view showing a rough configuration of semiconductor light-emitting device 110 used in light emission device 1 and a radiation pattern of the laser light emitted from semiconductor light-emitting device 110 according to the present embodiment. A three-dimensional coordinate system defined by x-, y-, and z-axes is illustrated in FIG. 4, but semiconductor light-emitting device 110 is mounted inside of semiconductor laser 100 with the three axes coinciding with those in FIG. 1. When the x- and y-axes are parallel, semiconductor light-emitting device 110 may also be mounted pointing the other way around. Note that semiconductor light-emitting device 210 has the same structure as semiconductor light-emitting device 110.

Hereinafter, a structure of semiconductor light-emitting device 110 will be described with reference to FIG. 4.

Semiconductor light-emitting device 110 is formed through epitaxial growth by layering n-type cladding layer 114 composed of Aluminium Gallium Nitride (AlGaN) and the like; active layer 115 of multiple quantum wells composed of Indium Gallium Nitride (InGaN) well layers, Gallium Nitride (GaN) barrier layers, and the like; and p-type cladding layer 116 composed of AlGaN and the like on semiconductor substrate 113 which is for example made of GaN. P-type cladding layer 116 includes ridge 117. Insulation layers 118 are disposed on a flat upper surface of p-type cladding layer 116, excluding ridge 117, and surfaces next to ridge 117. P-electrode 119 is disposed on an upper surface of ridge 117. A lower surface of semiconductor substrate 113 includes n-electrode 112.

N-electrode 112 and p-electrode 119 are formed through alloy deposition and the like using gold (Au) as a base. Stimulated emission of light occurs within a region of active layer 115 disposed below ridge 117 by applying a voltage to p-electrode 119 and n-electrode 112 allowing electric current to flow from p-electrode 119 to n-electrode 112. Since the refractive index of n-type cladding layer 114 and p-type cladding layer 116 is lower than the refractive index of active layer 115, which is thin, light gets confined therein. Moreover, p-electrode 119, which is disposed exterior to p-type cladding layer 116, is strip-shaped, and the flow of the electric current is limited to the strip of p-electrode 119 since insulation layers 118 are disposed in the other areas. As a result, the emission area is limited in size horizontally. The light generated in these horizontally and vertically limited spaces becomes amplified laser light due to the light reflecting countless of times on the front and back edge cleavages of active layer 115, and is emitted outward.

In the present embodiment, semiconductor laser 100 including semiconductor light-emitting device 110 emits blue laser light with a wavelength of approximately 450 nm. The area indicated with an ellipse below ridge 117 in FIG. 4 (area corresponding with near-field pattern 501 described later) is the emission area of the laser light. The axes perpendicular to and parallel with active layer 115 in semiconductor light-emitting device 110 are generally respectively called the fast axis and the slow axis. At a position sufficiently close to the emission area of semiconductor light-emitting device 110, near-field pattern 501 is an ellipse with its major axis along the slow axis. However, after the laser light is emitted from active layer 115, the diameters of the slow and fast axes of the ellipse gradually grow larger due to diffraction. Here, the diameter of the fast axis grows considerably larger than the diameter of the slow axis. Accordingly, far-field pattern 502 is an ellipse with its major axis along the fast axis. Hereinafter, the fast and slow axes of the laser light will be respectively referred to as Ax-axis and Ay-axis.

In light emission device 1 according to the present embodiment, semiconductor light-emitting device 110 is fixed on top of submount 111 such that the direction of the x-, y-, and z-axes in FIG. 4 coincide with those in FIGs 1 to 3. The x- and y-axes may also point the other way around. In other words, the fast and slow axes of semiconductor light-emitting device 110 respectively run parallel with the x- and y-axes. First excitation light beam 101 is focused along the fast and slow axes by light concentration section 10. With this, first excitation light beam 101 is radiated on wavelength converter 160 with a beam spot proximate to the focal point which reproduces the shape of near-field pattern 501. The same applies to second excitation light beam 201 emitted from semiconductor light-emitting device 210.

Light concentration section 10 includes first optical system 11 and second optical system 12. In the present embodiment, first optical system 11 includes aspheric lenses 120 and 220, and cylindrical lenses 130 and 230. Second optical system 12 includes cylindrical mirrors 150 and 250. In the present embodiment, cylindrical mirrors 150 and 250 are cylindrical concave mirrors. Moreover, light emission device 1 further includes fixed mirror 180 deflecting the optical path of first excitation light beam 101, and fixed mirrors 280 and 281 deflecting second excitation light beam 201.

Aspheric lenses 120 and 220 are collimating lenses that convert the laser light emitted from semiconductor light-emitting devices 110 and 210 to collimated light, and are optimized to keep spherical aberration thereof at an absolute minimum.

Cylindrical lenses 130 and 230 are curved along the fast axes of semiconductor light-emitting devices 110 and 210, and have their focal points on wavelength converter 160.

Cylindrical mirrors 150 and 250 are each curved along the slow axis of semiconductor light-emitting devices 110 and 210, and have their focal points on wavelength converter 160. Here, the placement of cylindrical mirrors 150 and 250 will be described with reference to the drawings.

FIG. 5 is a lateral view showing a placement of cylindrical mirrors 150 and 250 of light emission device 1 according to the present embodiment. In FIG. 5, optical projection system 170 and the like are omitted.

As illustrated in FIG. 5, cylindrical mirrors 150 and 250 are disposed symmetrical to each other with respect to the normal line of incident surface 160i (dash-dotted line illustrated in FIG. 5) on which first excitation light beam 101 and second excitation light beam 201 are incident. With this, first excitation light beam 101 and second excitation light beam 201 are respectively reflected by cylindrical mirrors 150 and 250, which are disposed symmetrical to each other with respect to incidence surface 160i of wavelength converter 160, and radiated on wavelength converter 160. With this, when first excitation light beam 101 and second excitation light beam 201 are scanned over the same position, a symmetrical light distribution with respect to the center of the radiation direction can be achieved when radiating the emission light forward from the fluorescent substance using an optical projection system and the like since a symmetrical scan shape can be obtained with respect to the center of the scan area of the excitation light on the fluorescent substance.

For example, first excitation light beam 101 is collimated by aspheric lens 120 disposed proximate to semiconductor laser 100. Subsequently, first excitation light beam 101 is focused along the fast axis by cylindrical lens 130 disposed between semiconductor laser 100 and light deflector 140. Furthermore, first excitation light beam 101 is focused along the slow axis by cylindrical lens 150 disposed between light deflector 140 and wavelength converter 160, after being deflected by light deflector 140. Moreover, since cylindrical lens 130 and cylindrical mirror 150, whose focal lengths differ from each other, are disposed such that their focal points are on the same position on wavelength converter 160, excitation light beam 101 is radiated on wavelength converter 160 with a beam spot proximate to the focal point which reproduces the shape of near-field pattern 501.

Light deflector 140 is an instrument for deflecting first excitation light beam 101 and second excitation light beam 201. Light deflector 140 includes one movable mirror 142 on which first excitation light beam 101 and second excitation light beam 201 are incident along different optical axes. In the present embodiment, movable mirror 142, for example, deflects incident light while being cyclically tilted back and forth about a rotation axis via a magnetic circuit.

Wavelength converter 160 receives and converts excitation light beam 101 and second excitation light beam 201 deflected by light deflector 140 to wavelength-converted light of a different wavelength, and emits the wavelength-converted light. In the present embodiment, wavelength converter 160 includes fluorescent substance 162. Fluorescent substance 162 converts first excitation light beam 101 and second excitation light beam 201 to fluorescent light that is wavelength-converted light. In the present embodiment, the incident surface of wavelength converter 160 on which first excitation light beam 101 and second excitation light beam 201 are incident faces optical projection system 170. With this, the incident and emission surfaces of wavelength converter 160 are the same, and efficiently dissipate heat since it is possible to dispose a highly thermally conductive component on the opposite side of the incident and emission surfaces. Accordingly, illumination device 2 can be made with high light-conversion efficiency, thermal properties and durability.

Fluorescent substance 162 includes, for example, a YAG fluorescent substance that is a crystalline garnet fluorescent substance, which is represented by the formula Ce-doped $A_3B_5O_{12}$. (A including one of Sc, Y, Sm, Gd, Tb, and Lu. B including one of Al, Ga, and In.) To be more specific, besides a Ce-doped $Y_3Al_5O_{12}$ single crystal, a Ce-doped $Y_3Al_5O_{12}$ polycrystal, or a ceramic YAG fluorescent substance mix of sintered Ce-doped $Y_3Al_5O_{12}$ and $Al_2O_3$ particles may also be used for fluorescent substance 162.

Moreover, fixed mirrors 180, 280, and 281 are disposed along the optical paths of first excitation light beam 101 and second excitation light beam 201, and are used for adjusting the position and propagation direction of the optical paths thereof along the slow axis.

Optical projection system 170 is an optical system for radiating on an illumination target (i) wavelength-converted light emitted from wavelength converter 160 that receives first excitation light beam 101 and second excitation light beam 201, and (ii) light scattered from first excitation light beam 101 and second excitation light beam 201 by wavelength converter 160. In the present embodiment, optical projection system 170 is a lens for focusing and projecting (i) the wavelength-converted light (fluorescent light) emitted with a Lambertian distribution from wavelength converter 160, and (ii) the scattered light from first excitation light beam 101 and second excitation light beam 201. In the present embodiment, optical projection system 170 includes first lens 171 and second lens 172. Optical projection system 170 including two lenses, first lens 171 and second lens 172, is disposed such that their combined focal point coincides on the surface of the fluorescent substance. With this, optical projection system 170 can project collimated light.

The optical paths of first excitation light beam 101 and second excitation light beam 201 to wavelength converter 160 (i.e., fluorescent substance 162) will be described next with reference to FIGs 1 to 3.

First excitation light beam 101 emitted from semiconductor laser 100 is incident on aspheric lens 120 disposed closely in front thereof and is converted to collimated light. Next, first excitation light beam 101 is incident on cylindrical lens 130 curved along the x-axis (fast axis of semiconductor light-emitting device 110), and first excitation light beam 101 is converted to convergent light along the fast axis. Since first excitation light beam 101 is not influenced by cylindrical lens 130 along its slow axis, first excitation light beam 101 propagates as collimated light. In the present embodiment, fixed mirror 180 is interposed along the optical path of first excitation light beam 101 in order to deflect the optical path of first excitation light beam 101 emitted from cylindrical lens 130. With this, as illustrated in FIG. 3, the optical path of first excitation light beam 101 is deflected and first excitation light beam 101 is incident on rotation axis Am of movable mirror 142 at incidence angle α1. First excitation light beam 101 reflected by light deflector 140 is incident on cylindrical mirror 150 which is disposed along the reflection direction. Cylindrical lens 150 is curved along the slow axis of first excitation light beam 101, and converts first excitation light beam 101 to convergent light therealong. Here, first excitation light beam 101 is not influenced by cylindrical lens 150 along the fast axis, and propagates to wavelength converter 160 at the same convergence angle as when converted by cylindrical lens 130. First excitation light beam 101 converted to convergent light by cylindrical lens 130 and cylindrical mirror 150 is incident on wavelength converter 160 disposed proximate to the focal points of cylindrical lens 130 and cylindrical mirror 150.

Second excitation light beam 201 emitted from semiconductor laser 200 is incident on aspheric lens 220 disposed closely in front thereof and is converted to collimated light. Next, second excitation light beam 201 is incident on cylindrical lens 230 curved along the x-axis (fast axis of semiconductor light-emitting device 210), and second excitation light beam 201 is converted to convergent light along its fast axis. Since second excitation light beam 201 is not influenced by cylindrical lens 230 along the slow axis, second excitation light beam 201 propagates as collimated light. In the present embodiment, fixed mirror 280 is interposed along the optical path of second excitation light beam 201 in order to deflect the optical path of second excitation light beam 201 emitted from cylindrical lens 230. With this, as illustrated in FIG. 3, the optical path of second excitation light beam 201 is deflected and second excitation light beam 201 is incident on rotation axis Am of movable mirror 142 from the same direction and at the same incidence angle $\alpha2$ (= $\alpha1$), but at a different position than first excitation light beam 101. In other words, second excitation light beam 201 has a different optical path than first excitation light beam 101, and is incident on rotation axis Am of movable mirror 142 parallel with the optical path of first excitation light beam 101. In other words, first excitation light beam 101 and second excitation light beam 201 pass through the plane including rotation axis Am of movable mirror 142 and are incident on movable mirror 142 at the same angle. In the light emission device with this configuration, the deflection angle and deflection direction of each excitation light beam are aligned following the tilting movement of movable mirror 142. Accordingly, the optical paths of first excitation light beam 101 and second excitation light beam 201 can easily be controlled. Moreover, in the present embodiment, in order to make the configuration of the optical system symmetrical with respect to the yz-plane, first excitation light beam 101 and second excitation light beam 201 are perpendicular to the reflection surface of movable mirror 142 at an angle in which the normal line of the reflection surface is aligned with the y-axis (rotation angle of movable mirror 142 is 0°), pass through the plane including rotation axis Am of movable mirror 142, and are incident on movable mirror 142 at the same angle.

Second excitation light beam 201 reflected by movable mirror 142 is incident on fixed mirror 281 disposed along the reflection direction, and is deflected to the opposite direction of first excitation light beam 101 relative to wavelength converter 160. Furthermore, second excitation light beam 201 is incident on cylindrical mirror 250 disposed symmetrical to cylindrical mirror 150 with respect to the normal line passing through the center of the scan area of the incidence surface of wavelength converter 160 on which second excitation light beam 201 is incident. Here, the center of the scan area is the midpoint of the locus of the incident point on the incidence surface of wavelength converter 160 on which first excitation light beam 101 and second excitation light beam 201 are incident.

Cylindrical lens 250 is curved along the slow axis of second excitation light beam 201, and converts second excitation light beam 201 to convergent light therealong. Here, first excitation light beam 201 is not influenced by cylindrical mirror 250 along the fast axis, and propagates to wavelength converter 160 at the same convergence angle as when converted by cylindrical lens 230. First excitation light beam 201 converted to convergent light by cylindrical lens 230 and cylindrical mirror 250 is incident on wavelength converter 160 disposed proximate to the focal points of cylindrical lens 230 and cylindrical mirror 250.

Fluorescent substance 162 including wavelength converter 160 partially converts first excitation light beam 101 and second excitation light beam 201 to fluorescent light that is wavelength-converted light with a broader wavelength distribution, and emits the fluorescent light outward. Moreover, the remaining light of each excitation light beam that is not converted to fluorescent light is scattered by fluorescent substance particles and fluorescent substance binder included in fluorescent substance 162, as well as particles mixed into fluorescent substance 162 when necessary, and is then emitted to the outside thereof. The fluorescent light and the scattered light from the excitation light beams is emitted perpendicularly with a Lambertian distribution with respect to the incidence surface of fluorescent substance 162 on which each excitation light beam is incident. Since people perceive the mix of fluorescent light and scattered light from each excitation light beam entering their eyes as light with a color depending on the ratio between fluorescent light and scattered light, the wavelength distribution of white light or any preferred color can be created by suitably adjusting the ratio to the thickness of fluorescent substance 162, the density of the fluorescent substance particles, and/or the like.

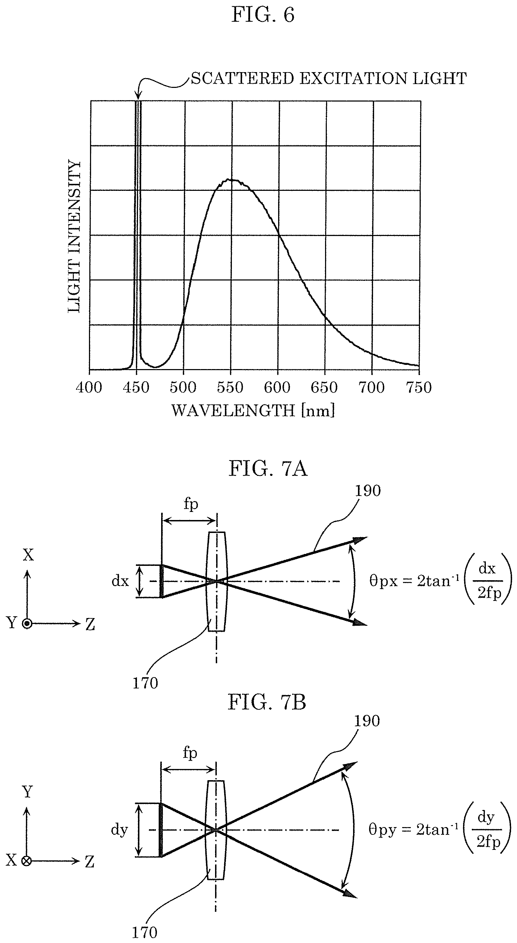

FIG. 6 is a graph showing the wavelength distribution of light emitted outward from fluorescent substance 162 according to the present embodiment. In the present embodiment, blue light with a wavelength of approximately 450 nm is used for each excitation light beam, and a YAG fluorescent substance that emits yellow fluorescent light excited with each excitation light beam is used for fluorescent substance 162.

In FIG. 6, the presence of a peak in light intensity around the wavelength of 450 nm is due to the scattered light from the excitation light beams not being converted to fluorescent light by fluorescent substance 162. The wavelengths longer than the wavelengths around the peak indicate the light intensity of the light converted to fluorescent light by fluorescent substance 162. The light of the spectral distribution shown in FIG. 6 is perceived by people as white light.

In the above configuration, excitation light beams 101 and 201, which are emitted respectively from semiconductor lasers 100 and 200, are incident on rotation axis Am of movable mirror 142 at two different positions from the same direction and at the same angle as illustrated in FIG. 2. In other words, first excitation light beam 101 and second excitation light beam 201 pass through the plane including rotation axis Am of movable mirror 142 and are incident on movable mirror 142 at the same angle. Furthermore, first excitation light beam 101 and second excitation light beam 201 are focused on the same coordinates on fluorescent substance 162 due to the effects of cylindrical lenses 130 and 230, and cylindrical mirrors 150 and 250. Here, cylindrical mirrors 150 and 250, fluorescent substance 162, and the like are disposed to make equal the optical path length of each excitation light beam from movable mirror 142 to the coordinates of the position where each excitation light beam is focused on fluorescent substance 162.

Furthermore, in order to use light emission device 1 for illumination device 2, optical projection system 170, whose combined focal point is the center of fluorescent substance 162, is disposed therebehind with respect to the projection direction. By scanning each excitation light beam over the fluorescent substance, the fluorescent light emitted from fluorescent substance 162 with a Lambertian distribution and the scattered light from each excitation light beam is incident on optical projection system 170, and is mixed and projected in the frontward direction of the device. With this, white light mixed from fluorescent light and excitation light can be projected.

Note that in order to gather as much light emitted from fluorescent substance 162 as possible, the incidence surface of optical projection system 170 needs to be close thereto. To make sure, however, that each excitation light beam incident on fluorescent substance 162 does not come in contact with optical projection system 170, each excitation light beam is radiated on fluorescent substance 162 at a large angle and unnecessary portions of optical projection system 170 are cut away. In the present embodiment, as illustrated in FIGs 1 and 3, a surface of first lens 171 of optical projection system 170 facing fluorescent substance 162 includes chamfer 171c on its outer edge. In other words, first lens 171 has a sloping surface because the portions of its outer edge facing fluorescent substance 162 that can possibly interfere with each excitation light beam are removed. Note that making chamfer 171c is not limited to cutting away a part of chamferless lens. For example, first lens 171 may be shaped to include chamfer 171c beforehand. In the present embodiment, incidence angle θin on fluorescent substance 162 is designed between approximately 70° and 80°. With this, an NA of 0.9 or more can be achieved for optical projection system 170.

In the present embodiment, each excitation light beam is radiated diagonally on the incidence surface of fluorescent substance 162. In other words, the incidence angle of each excitation light beam is larger than 0°. Accordingly, when the beam diameter of each excitation light beam in a cross section perpendicular to its optical axis is dy, then the radiation spot diameter thereof on the incident surface of fluorescent substance 162 is dy / cosθin. For example, when the incidence angle is between approximately 70° and 80°, then the magnification factor from dy is about 2.9 to 5.8 times. In order to control the light distribution of the projection light accurately, the beam diameter of each excitation light beam along the slow axis may be as small as possible since a smaller radiation spot diameter is better.

Projection light 190 emitted from optical projection system 170 will be described with reference to the drawings.

FIGs 7A and 7B show the relationship between focal length fp of optical projection system 170 and, respectively, radiation angles θpx and θpy along the x- and y-axes of projection light 190 according to the present embodiment. In FIGs 7A and 7B, optical projection system 170 is illustrated simplified as one lens.

As illustrated in FIGs 7A and 7B, when the focal length of optical projection system 170 is fp and light emission widths along the x- and y-axes of fluorescent substance 162, which is disposed on the focal point of optical projection system 170, are dx and dy, radiation angles θpx and θpy of projection light 190 projected frontward are both expressed as below:

[Math. 1]

$$\theta_{px} = 2\tan^{-1}\left(\frac{dx}{2fp}\right)$$

$$\ldots \text{Expression (Expr.) 1-1}$$

[Math. 2]

$$\theta_{py} = 2\tan^{-1}\left(\frac{dy}{2fp}\right)$$

$$\ldots \text{Expr. 1-2}$$

When light emission device 1 and illumination device 2 according to the present embodiment respectively function as a scanning light emission device and a scanning illumination device, movable mirror 142, on which first excitation light beam 101 and second excitation light beam 201 are incident, cyclically rotates back and forth within a fixed angle range about rotation axis Am illustrated in FIG. 3. Consequently, each excitation light beam is scanned over the surface of wavelength converter 160 (i.e., fluorescent substance 162) along the x-axis while its propagation direction changes depending on the tilt angle of movable mirror 142. The range of the optical paths along which the light is scanned is illustrated with dash-dotted lines in FIG. 3. Here, the light emission width, i.e., the scan range, with respect to the radiation angle range as required from the illumination device can be determined based on Expr. 1-1 and Expr. 1-2. The optical systems according to the present embodiment are designed to align the x-axis coordinates on fluorescent substance 162 of first excitation light beam 101 and second excitation light beam 201 temporally and positionally.

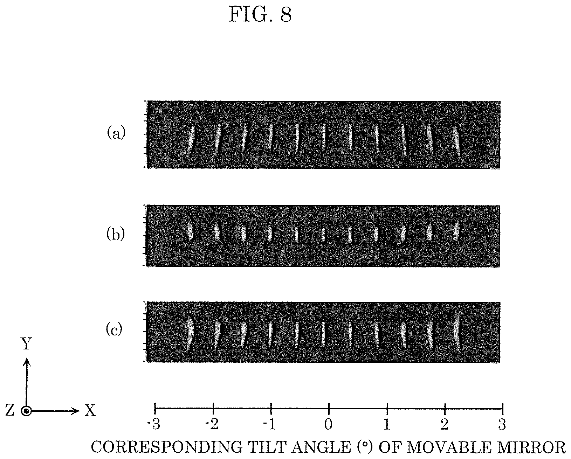

FIG. 8 shows examples of the relationship between the rotation angles of movable mirror 142 and the radiation spot shapes of each excitation light beam on the surface of fluorescent substance 162 in light emission device 1 according to the present embodiment. Image (a) of FIG. 8 shows the radiation spot shapes formed by first excitation light beam 101 emitted by semiconductor laser 100, and image (b) shows the radiation spot shapes formed by second excitation light beam 201 emitted by semiconductor laser 200. Moreover, image (c) shows the radiation spot shapes formed by first excitation light beam 101 and second excitation light beam 201.

As illustrated in FIG. 8, by aligning the scan time and positions of first excitation light beam 101 and second excitation light beam 201, the combined radiation spots formed by both excitation light beams are scanned on fluorescent substance 162 as one radiation spot. Therefore, by synchronizing the excitation light beams with the rotation angle of movable mirror 142 and simultaneously controlling the ON/OFF (i.e., turning the light on and off) of the beams incident on movable mirror 142, the plurality of light beams can be caused to emit and not emit light, as well as the timing thereof on the scannable area of fluorescent substance 162 by the plurality of excitation light beams. Furthermore, adjustable light distribution like ADB can be achieved since a non-radiation area can be formed within the frontward angle range corresponding to the non-emission area of fluorescent substance 162 by using Expr. 1-1 and Expr. 1-2.

Hereinafter, the advantageous effects produced by light emission device 1 and illumination device 2 according to the present embodiment will be described.

Generally speaking, when the beam parameter products (BPP), which indicate the beam quality of the laser light, along the x- and y-axes are respectively BPPx and BPPy, the divergence angles (double angle) are θx (mrad) and θy (mrad), and the beam waist radii are rx (mm) and ry (mm), then the BPP is defined as follows:

[Math. 3]

$$BBPx = \frac{rx \times \theta x}{2}$$

$$\ldots \text{Expr. 2-1}$$

[Math. 4]

$$BBPy = \frac{ry \times \theta y}{2}$$

$$\ldots \text{Expr. 2-2}$$

This BPP is a conserved quantity and does not change when assuming the light is transmitted through a perfect optical system without aberration.

However, when the focal length of cylindrical lenses 130 and 230 is fx, the focal length of cylindrical mirrors 150 and 250 is fy, the incident beam diameter along the x- and y-axes (i.e., the fast and slow axes) are respectively Dx and Dy, and the BPPs indicating the beam quality along the x- and y-axes are respectively BPPx and BPPy, then spot diameters dx and dy along each axis of the beam waist are defined as follows if the optical system, such as a lens, has no aberration:

[Math. 5]

$$dx = 4fx \times \frac{BPPx}{Dx}$$

$$\ldots \text{Expr. 3-1}$$

[Math. 6]

$$dy = 4fy \times \frac{BPPy}{Dy}$$

$$...\mathrm{Expr.}\ 3\text{-}2$$

From these expressions, it can be understood that the beam waist spot diameter is proportional to the beam quality and the focal lengths of the focus lenses.

The lasers of semiconductor light-emitting devices 110 and 210, which are high-output semiconductor lasers used in the present embodiment, oscillate in a single mode along the fast axis which runs along thickness of active layer 115, and in multiple modes along the slow axis in which the optical confinement is larger than the thickness of active layer 115. Accordingly, first excitation light beam 101 and second excitation light beam 201 have far-field patterns satisfying $\theta x > \theta y$ due to the effects of diffraction. Moreover, due to the influence of the oscillation modes, BPPx < BPPy. In other words, the fast axis is the Ax-axis with good beam quality and the slow axis is the Ay-axis with poor beam quality. However, the excitation light beams emitted from semiconductor light-emitting devices 110 and 210 are respectively converted to collimated light by aspheric lenses 120 and 220, which are symmetrical collimating lenses. Accordingly, the incident beam diameters on cylindrical lenses 130 and 230 are proportional to $\theta x$ and $\theta y$, and satisfy Dx > Dy. Therefore, (BPPx / Dx) < (BPPy / Dy), and assuming that this beam is made narrower by one axisymmetric lens in which focal lengths fx = fy, then the relationship between spot diameters dx and dy in Expr. 3-1 and Expr. 3-2 becomes dx < dy and the beam diameter ratio is constant.

Since (BPPy / Dy) of a multimode semiconductor laser is generally several times or tens of times more than (BPPx / Dx), the light focus along the fast axis is much better compared to that of the slow axis. Assuming that even when fx > fy by dividing the optical concentration system along two axes, it is difficult to reverse the size relationship between spot diameters dx and dy due to limitation of space in the device. Therefore, when scanning in one dimension, a more detailed image pattern can be displayed by scanning along the Ax-axis with good beam quality, in other words, the x-axis, than by scanning along the Ay-axis with poor beam quality.

With ADB in headlights for cars, among the light radiated in the movement direction of the car, an area in which the light is not radiated can be created by partially not emitting light horizontally for the purpose of preventing glare on oncoming vehicles or pedestrians due to the radiated light. Furthermore, it is desired that the positions and dimensions of the areas on which no light is shined are be altered with a fine pitch and as smoothly as possible to adjust to the driving conditions of moving cars changing moment by moment. Accordingly, a configuration in which the axis with a small spot diameter, in other words the x-axis, is aligned horizontally, which is the scan direction of the excitation light beam, is suitable for ADB. Accordingly, the horizontal direction scanned along one dimension in the present embodiment is the x-axis, and this direction is aligned with the axis with good beam quality of the semiconductor light-emitting device.

As described above, in light emission device 1 according to the present embodiment, since the configuration of the device can be simplified by integrating light deflector 140, which deflects first excitation light beam 101 and second excitation light beam 201, as one movable mirror 142, the device can expectedly be scaled down, have the number of its components reduced, have its manufacturing cost cut down, and can be assembled more easily. Moreover, adjustable light distribution typical of ADB can be achieved by using illumination device 2 including light emission device 1 for headlights for cars. In this case, light source 3 is turned off when each excitation light beam is radiated on the coordinate region of wavelength converter 160 corresponding to the region of the scannable region so as to not radiate the emission light (projection light 190) on a part of the scannable region. Here, first excitation light beam 101 and second excitation light beam 201 can be deflected by controlling movable mirror 142 of light deflector 140. Accordingly, in light emission device 1 according to the present disclosure, individual responsiveness differences between light deflectors with respect to input signals do not need to be taken in account like when two light deflectors are used to deflect first excitation light beam 101 and second excitation light beam 201. Therefore, the timing of radiating excitation light beam 101 and second excitation light beam 201 on wavelength converter 160, along with the coordinate region where each excitation light beam is not emitted on wavelength converter 160, can easily be aligned. Accordingly, the control timing between first excitation light beam 101 and second excitation light beam 201 does not need to be aligned completely, and the plurality of light sources can be controlled simultaneously with the same circuit. In this manner, the control system in light emission device 1 according to the present disclosure can be simplified. Furthermore, by aligning the control timing of first excitation light beam 101 and second excitation light beam 201, the output and quality of light emitted by emission device 1 can be improved.

As described above, in the present embodiment, (i) the plurality of excitation light beams are radiated on rotation axis Am of movable mirror 142, (ii) the plurality of light beams are incident on one movable mirror 142 from the same direction and at the same angle, and (iii) the optical lengths of the plurality of light beams from movable mirror 142 to fluorescent substance 162 are equal. In light emission device 1a and illumination device 2a with these three features, the radiation spot movement degree on fluorescent substance 162 per unit of degree of the rotation angle of movable mirror 142 is equal for the plurality of excitation light beams. Accordingly, the plurality of excitation light beams simultaneously arrive on fluorescent substance 162 with the same coordinates on the scan axes. As a result, the plurality of excitation light beams emitted from the plurality of semiconductor lasers can be scanned while aligning their radiation positions (coordinates) and timing on fluorescent substance 162.

Moreover, illumination device 2 according to the present embodiment includes light emission device 1 and optical projection system 170. Illumination device 2 can be used for various types of illumination devices that require a specific light distribution, such as headlights for cars or spotlights due to due to first excitation light beam 101 and second excitation light beam 201 being deflected by light deflector 140 and scanned over wavelength converter 160. Furthermore, illumination device 2 can freely adjust its light distribution.

VARIATIONS

The light emission device and illumination device according to the present disclosure have been described above based on the embodiment, but the present disclosure is not limited thereto.

For example, in the present embodiment, two semiconductor lasers 100 and 200 are used, but as long as the conditions for the plurality of excitation light beams incident on one movable mirror 142 are met, there may also be more than two light sources. Moreover, similar results can also be produced when the plurality of excitation light beams generated are superimposed on the same axis beforehand. Hereinafter, a variation with more than two light sources will be described with reference to the drawings.

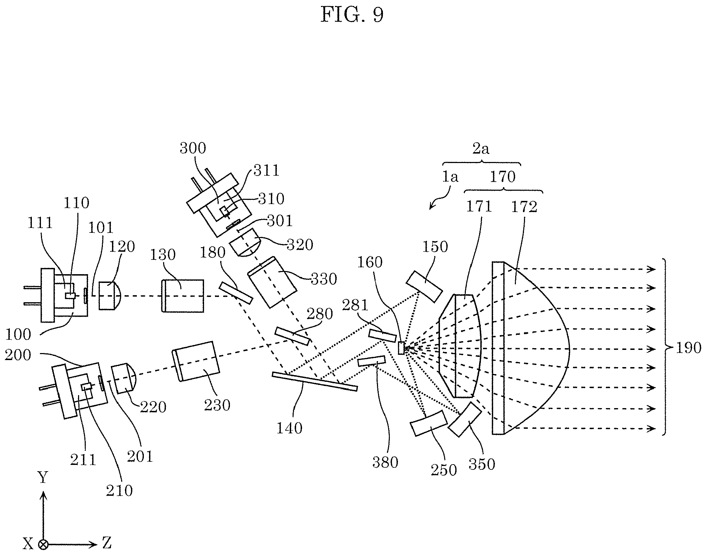

FIG. 9 is a lateral view showing the optical system configuration of light emission device 1a and illumination device 2a according to the variation. Light emission device 1a and illumination device 2a according to the present variation further include, as illustrated in FIG. 9, semiconductor laser 300, in addition to semiconductor lasers 100 and 200. Semiconductor laser 300 emits third excitation light beam 301, and mainly includes submount 311 and semiconductor light-emitting device 310 fixed thereto. Light emission device 1a and illumination device 2a according to the present variation further include aspheric lens 320, cylindrical lens 330, and fixed mirror 380. Light emission device 1a and illumination device 2a according to the variation produce similar effects to the above embodiment. This also applies when there are four or more light sources.

Moreover, the concentration lenses used in the present embodiment are a cylindrical lens for focusing the light along the fast axis and a cylindrical mirror for focusing the light along the slow axis, but as long as the optical elements have ample light focus along one axis, the lenses may be either a lens or mirror. Moreover, fixed mirrors 180, 280, and 281 are disposed for suitably changing the propagation direction of the excitation light beams to contain their optical paths within a fixed range perpendicular thereto, but the amount of mirrors used does not matter. These may all be chosen depending on the conditions of available space, casing size restrictions, and the configuration of the optical projection system.

Moreover, in the above embodiment, two cylindrical lenses 130 and 230 curved along the fast axis for focusing first excitation light beam 101 and second excitation light beam 201 therealong are used, but one cylindrical lens 530 may also be used. The variation with this configuration will be described with reference to the drawings.

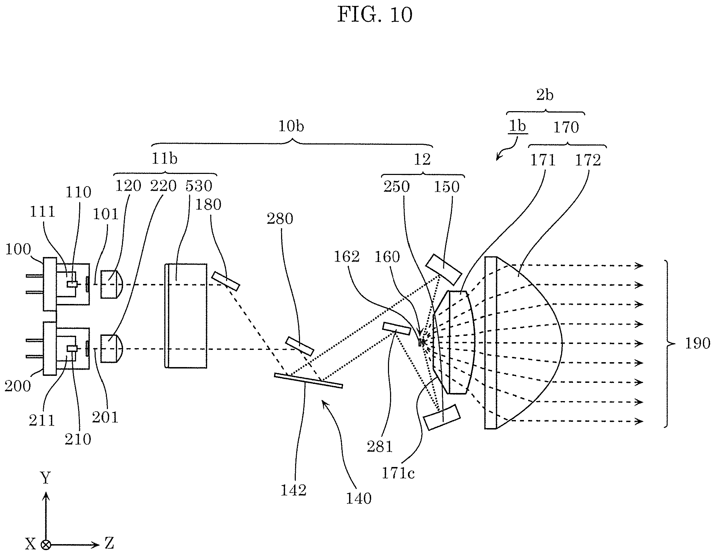

FIG. 10 is a lateral view showing the optical system configuration of light emission device 1b and illumination device 2b according to the present variation. Light emission device 1b according to the present variation includes light concentration section 10b. Light concentration section 10b includes first optical system 11b and second optical system 12. First optical system 11b includes aspheric lenses 120 and 220, and cylindrical lens 530. Cylindrical lens 530 focuses first excitation light beam 101 and second excitation light beam 201 along the fast axis. In the present variation, both excitation light beams are incident on the same incidence surface of cylindrical lens 530 at the same angle and different positions, and determine the necessary effective diameter of cylindrical lens 530 based on the incident beam point and beam size. In this manner, the configuration of light emission device 1b and illumination device 2b can be simplified due to first excitation light beam 101 and second excitation light beam 201 being focused by one cylindrical lens 530. Moreover, adjustment work on the optical axes and the like in light emission device 1b and illumination device 2c can be reduced.

Moreover, first excitation light beam 101 and second excitation light beam 201 emitted from semiconductor lasers 100 and 200 are focused on the same place on wavelength converter 160, but as long as the coordinates over which the excitation light beams are scanned along the x-axis (fast axis) are aligned, the coordinates along the y-axis (slow axis) may deviate. In this case, the light intensity distribution and projection light distribution corresponding to the combined intensity distribution can be achieved within the radiation angle range corresponding to the combined length of both excitation light beam radiation spots. In this case, although the brightness of the projection light is reduced, light saturation, thermal saturation, thermal quenching, and thermal damage can be prevented since the light density of the excitation light beams radiated on fluorescent substance 162 including wavelength converter 160 is not as high as when the excitation light beams are focused on the same point.

Moreover, the cylindrical lenses are disposed to have their focal point on fluorescent substance 162, but as long as the beam spots radiated on fluorescent substance 162 are on the area that reproduces the shape of the near-field pattern, the position of the cylindrical lenses may slightly deviate. The aspect ratios of the elliptic beams can be corrected slightly using this deviation.

Moreover, first excitation light beam 101 and second excitation light beam 201 are incident on aspheric lens 120 disposed closely in front of semiconductor lasers 100 and 200, and are converted to collimated light, but may also be converted to slightly converging light or slightly diverging light. In this case, fluorescent substance 162 may be disposed proximate to where the excitation light beams are focused to most adjusting to the effects of the cylindrical lenses for each axis.

Moreover, in the present embodiment, the excitation light incidence and emission surfaces of fluorescent substance 162 are the same, but a configuration in which the excitation light beams are emitted from the other side of the incidence surface, in other words a light-transmissive configuration, may also be used. In this case, since the incidence angle of the excitation light beams on fluorescent substance 162 need not be increased to avoid optical projection system 170, the incidence angle can be configured more freely, and the configuration can be simplified.

Moreover, in the present embodiment, movable mirror 142 scans only as a line in one dimension along the x-axis (fast axis), but may also be capable of scanning in two dimensions simultaneously by adding the y-axis. In this case, the direction necessary for scanning more minutely or the direction in which the radiation range is wider, for example the horizontal radiation direction in ADB, is disposed so that this direction becomes the axis with good beam quality, in other words the fast axis of the laser light.

Moreover, the optical projection system in the illumination device of the above embodiment includes two lenses, but this number may be increased for correcting chromatic aberration or surface curvature. Only one lens may also be used when the illumination device is not used much and a slight radiation blur does not pose a problem. A reflector (reflection mirror) may also be used. For example, when the reflector is a paraboloid of revolution, the fluorescent light generated from fluorescent substance 162 with a Lambertian distribution and the scattered light from the excitation light beams can be emitted further in a predetermined direction as substantially collimated light by disposing fluorescent substance 162 on the focal point of the reflector.

Moreover, in the above embodiment, the light deflector is a movable mirror driven by a magnetic circuit, but as long as the excitation light beams can be scanned repeatedly over the same position on fluorescent substance 162, a microelectromechanical system (MEMS) mirror driven by piezoelectricity, or a polygon or galvano mirror using a motor, another method may also be used.

Moreover, in the above embodiment, fluorescent substance 162 is disposed on wavelength converter 160, but any other wavelength conversion element may also be used.

The light emission device and illumination device of the present disclosure have been described based on the above embodiments, but the present disclosure is not limited thereto. Embodiments resulting from variations of the above embodiment conceived by those skilled in the art, as well as embodiments resulting from partial combinations of components in the above embodiments are included within the present disclosure so long as they do not depart from the scope thereof.

INDUSTRIAL APPLICABILITY

The light emission device and the illumination device of the present disclosure are suitable for an illumination device with adjustable light distribution which has high brightness and includes a function in which a specific area is radiated or not radiated with light tracking the movements of an illumination target, such as headlights for cars with ADB, spotlights that track an illumination target, and searchlights.

REFERENCE MARKS IN THE DRAWINGS

1, 1a, 1b Light emission device 2, 2a, 2b Illumination device 3 Light source
10, 10b Light concentration section
11, 11b Second optical system
12 Second optical system
100, 200, 300 Semiconductor laser
101 First excitation light beam
110, 210, 310 Semiconductor light-emitting device
111, 211, 311 Submount
112 N-electrode
113 Substrate
114 N-type cladding layer
115 Active layer

116 P-type cladding layer
117 Ridge
118 Insulation layer
119 P-electrode
120, 220, 320 Aspheric lens
130, 230, 330, 530 Cylindrical lens
140 Light deflector
142 Movable mirror
150, 250 Cylindrical mirror
160 Wavelength converter
162 Fluorescent substance
170 Optical projection system
171 First lens
171c Chamfer
172 Second lens
180, 280, 281, 380 Fixed mirror
190 Projection light
201 Second excitation light beam
301 Third excitation light beam
501 Near-field pattern
502 Far-field pattern
Am Rotation axis

**Claims**

1. A light emission device, comprising:

   a plurality of light sources;
   a light deflector that deflects excitation light beams emitted by the plurality of light sources; and
   a wavelength converter that receives and converts the excitation light beams deflected by the light deflector to wavelength-converted light of a different wavelength, and emits the wavelength-converted light, wherein
   the light deflector includes one movable mirror on which the excitation light beams are incident along different optical axes, and
   the excitation light beams have equally long optical path lengths from the one movable mirror to the wavelength converter.

2. A light emission device, comprising:

   a plurality of light sources;
   a light deflector that deflects light beams emitted by the plurality of light sources; and
   a wavelength converter that receives and converts the excitation light beams deflected by the light deflector to wavelength-converted light of a different wavelength, and emits the wavelength-converted light, wherein
   the light deflector includes one movable mirror on which the excitation light beams are incident along different optical axes,
   the one movable mirror rotates about a rotation axis, and
   the excitation light beams propagate through a plane that includes the rotation axis and are incident on the one moveable mirror at equal angles.

3. The light emission device according to claim 1 or 2, wherein
   the excitation light beams are each reflected by a corresponding one of two reflectors to the wavelength converter, the two reflectors being symmetrically disposed with respect to a normal line of an incidence surface of the wavelength converter on which the excitation light beams are incident.

4. The light emission device according to any one of claims 1 to 3, wherein
   the wavelength converter is a fluorescent substance.

5. An illumination device, comprising:

the light emission device according to any one of claims 1 to 4; and

an optical projection system for radiating on an illumination target (i) the wavelength-converted light emitted from the wavelength converter that receives the excitation light beams, and (ii) light scattered from the excitation light beams by the wavelength converter.

6. The illumination device according to claim 5, wherein
an incidence surface of the wavelength converter on which the excitation light beams are incident faces the optical projection system.

FIG. 1

# FIG. 2

# FIG. 3

## FIG. 4

FAST AXIS: AX-AXIS

SLOW AXIS: AY-AXIS

## FIG. 5

## FIG. 6

SCATTERED EXCITATION LIGHT

LIGHT INTENSITY

400 450 500 550 600 650 700 750
WAVELENGTH [nm]

## FIG. 7A

X

Y ⊙ → Z

fp

dx

190

170

$\theta px = 2\tan^{-1}\left(\dfrac{dx}{2fp}\right)$

## FIG. 7B

Y

X ⊗ → Z

fp

dy

190

170

$\theta py = 2\tan^{-1}\left(\dfrac{dy}{2fp}\right)$

FIG. 8

(a)

(b)

(c)

Y

Z ⊙ ⟶ X

-3  -2  -1  0  1  2  3

CORRESPONDING TILT ANGLE (°) OF MOVABLE MIRROR

EP 3 492 803 A1

FIG. 9

FIG. 10

**INTERNATIONAL SEARCH REPORT**

| International application No. |
| --- |
| PCT/JP2017/026082 |

A. CLASSIFICATION OF SUBJECT MATTER
*F21S8/12*(2006.01)i, *F21W101/10*(2006.01)n, *F21Y115/30*(2016.01)n

According to International Patent Classification (IPC) or to both national classification and IPC

B. FIELDS SEARCHED

Minimum documentation searched (classification system followed by classification symbols)
F21S8/12, F21W101/10, F21Y115/30

Documentation searched other than minimum documentation to the extent that such documents are included in the fields searched
Jitsuyo Shinan Koho        1922–1996    Jitsuyo Shinan Toroku Koho    1996–2017
Kokai Jitsuyo Shinan Koho   1971–2017    Toroku Jitsuyo Shinan Koho    1994–2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2014-29858 A  (Valeo Vision),<br>13 February 2014 (13.02.2014),<br>paragraphs [0033] to [0088]; fig. 8<br>& US 2014/0029282 A1<br>paragraphs [0080] to [0149]; fig. 8<br>& EP 2690352 A1        & FR 2993831 A<br>& CN 103574473 A | 1-6 |
| A | JP 2009-200079 A  (Seiko Epson Corp.),<br>03 September 2009 (03.09.2009),<br>paragraph [0043]<br>(Family: none) | 1-6 |
| A | JP 2014-142369 A  (Zero Lab Co., Ltd.),<br>07 August 2014 (07.08.2014),<br>paragraphs [0011] to [0029]; fig. 1 to 4<br>(Family: none) | 2-6 |

☐ Further documents are listed in the continuation of Box C.        ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    22 September 2017 (22.09.17) | Date of mailing of the international search report<br>    10 October 2017 (10.10.17) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**EP 3 492 803 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011222238 A
- JP 2014029858 A